# EUROPÄISCHE PATENTSCHRIFT

(11) **EP 2 819 492 B1**
(45) Veröffentlichungstag und Bekanntmachung des Hinweises auf die Patenterteilung: **28.03.2018**
(21) Anmeldenummer: 14171870.0
(22) Anmeldetag: 11.06.2014
(51) Int. Cl.: H05K 3/28

(54) **MID-Bauteil, Verfahren zur Herstellung**
MID component, method for the preparation of the same
Composant MID, procédé de fabrication

(30) Priorität: 26.06.2013 DE 102013212254
(43) Veröffentlichungstag der Anmeldung: 31.12.2014
(73) Patentinhaber: ROBERT BOSCH GMBH, 70442 Stuttgart (DE)
(72) Erfinder: Kugler, Andreas, 73553 Alfdorf (DE)

(56) Entgegenhaltungen:
- DE-A1-102007 031 980
- DE-A1-102010 041 121
- US-A1- 2012 240 396
- KAZUHITO HIKASA ET AL: "Development of Flexible Bumped Tape Interposer", FURUKAWA REVIEW, Bd. 24, 1. Oktober 2003 (2003-10-01), Seiten 59-64, XP055038918,
- FELDMANN K ET AL: "MID in the automotive industry-potentials, benefits and applications", ELECTRONICS MANUFACTURING TECHNOLOGY SYMPOSIUM, 1998. IEMT-EUROPE 1998 . TWENTY-SECND IEEE/CPMT INTERNATIONAL BERLIN, GERMANY 27-29 APRIL 1998, NEW YORK, NY, USA,IEEE, US, 27. April 1998 (1998-04-27), Seiten 76-81, XP010309424, DOI: 10.1109/IEMTE.1998.723063 ISBN: 978-0-7803-4520-1

## Beschreibung

Die Erfindung betrifft ein MID-Bauteil für ein Steuergerät oder einen Sensor, insbesondere eines Fahrzeugs, mit einem Schaltungsträger und mit einer Kunststoffumspritzung, die den Schaltungsträger zumindest bereichsweise einhaust.

Ferner betrifft die Erfindung ein Verfahren zum Herstellen eines derartiges MID-Bauteils.

### Stand der Technik

MID-Bauteile sowie Verfahren zu deren Herstellung der Eingangs genannten Art sind aus dem Stand der Technik bekannt. Als MID-Bauteil (MID = Molded Interconnected Device = spritzgegossener Schaltungsträger) wird in der Regel ein elektronisches Bauteil bezeichnet, bei dem mindestens eine metallische Leiterbahn auf einem Kunststoffträger angeordnet ist. Aufgrund ihrer Robustheit und ihrer kompakten Bauweise werden MID-Bauteile häufig im Automobilbau verwendet. Derzeit werden MID-Bauteile in dreidimensionaler Gestaltung in unterschiedlichen Technologien gefertigt. So offenbart beispielsweise die DE 10 2010 041 121 A1 einen Schaltungsträger mit einem Lead-Frame (Stanzgitter), der in eine Spritzform eingesetzt und mit Kunststoff umspritzt wird, so dass die Leiterbahnen innerhalb des Kunststoffs verlaufen. Durch Aufbringen von weiteren Leiterbahnen auf der Außenseite des Kunststoffteils können damit mehrlagige Leiterbahnstrukturen realisiert werden. Weiterhin ist aus der Offenlegungsschrift US 2012/0240396 A1 bereits ein Bauteil mit einem Schaltungsträger bekannt, auf welchem elektrische/elektronische Bauteile angeordnet sind, und der bereichsweise aus einer Einhausung herausgeführt ist und außerhalb der Einhausung wenigstens eine elektrisch leitende Kontaktstelle aufweist. Der Schaltungsträger kann dabei als einschichtige oder mehrschichtige Leiterplatte oder als auf einer Metallplatte aufgebrachte Leitplattenfolie ausgebildet sein.

### Offenbarung der Erfindung

Das erfindungsgemäße MID-Bauteil mit den Merkmalen des Anspruchs 1 hat den Vorteil, dass es besonders einfach herzustellen ist und insbesondere eine leicht zu kontaktierende elektrisch leitfähige beziehungsweise elektrische Kontaktstelle zur Verfügung stellt. Das erfindungsgemäße MID-Bauteil zeichnet sich dadurch aus, dass der Schaltungsträger als flexibler Interposer ausgebildet ist, der mit mindestens einem elektrischen/elektronischen Bauteil bestückt ist und wenigstens die eine bereits erwähnte Kontaktstelle aufweist, und dass ein die Kontaktstelle aufweisender Abschnitt des Interposers außerhalb der Kunststoffumspritzung angeordnet ist. Damit ist ein Abschnitt des Interposers außerhalb des durch die Kunststoffumspritzung gebildeten Gehäuses angeordnet und kann leicht kontaktiert werden. Durch das Vorsehen der Kontaktstelle an diesem Abschnitt ist eine einfache Kontaktierbarkeit für das MID-Bauteil gewährleistet. Dadurch, dass der aus dem Gehäuse herausragende Abschnitt des Interposers ebenfalls flexibel ist, lassen sich vielfältige Kontaktierungsmöglichkeiten für das MID-Bauteil erreichen, so dass beispielsweise eine Anpassung von Anschlusssteckern an bestimmte Bauraumbedingungen nicht mehr unbedingt notwendig ist. Bevorzugt ist der Interposer als flexible Leiterplatte ausgebildet. Besonders bevorzugt ist vorgesehen, dass der Interposer einen 3-lagigen Aufbau mit einer strukturierten Cu-Metallisierung auf PI-Material oder LCP aufweist. Auf dem Interposer können elektronische Bauteile in bekannter Technologie montiert sein. Zusätzlich ist es auch denkbar, ein oder mehrere elektronische Bauteile in die flexible Leiterplatte zu integrieren. Die Kontaktierung des Interposers an dem herausragenden Abschnitt erfolgt bevorzugt durch Klemmen, mittels Steckverbinder oder durch den Einsatz von ACA-Klebstoff.

Gemäß einer vorteilhaften Weiterbildung der Erfindung ist vorgesehen, dass der Abschnitt ein Randabschnitt des Interposers ist. Dadurch ist der aus dem Kunststoffumspritzungsgehäuse herausragende Teil des Interposers besonders flexibel und variabel an äußere Rahmenbedingungen anformbar beziehungsweise anpassbar. Auch kann der Randabschnitt beispielsweise als Steckerleiste zur Aufnahme in einem Anschlusssteckerelement genutzt werden.

Bevorzugt ist vorgesehen, dass der Interposer als Interposerfolie ausgebildet ist. Die Interposerfolie ist besonders flexibel und erlaubt es auf einfache Art und Weise, eine gewünschte dreidimensionale Gestaltung des MID-Bauteils zu realisieren. Vorzugsweise ist die Kunststoffumspritzung ebenfalls dünn gestaltet, besonders bevorzugt ebenfalls flexibel, um die Erzeugung dreidimensionaler Formen zu erleichtern.

Gemäß einer vorteilhaften Weiterbildung der Erfindung ist vorgesehen, dass das elektrische/elektronische Bauteil in der Kunststoffumspritzung vollständig eingehaust ist. Damit liegt das Bauteil geschützt im Inneren des Gehäuses, während die Kontaktstellen von außen leicht erreichbar sind. Vorzugsweise weist der Schaltungsträger beziehungsweise die Interposerfolie/der Interposer mehrere Kontaktstellen auf, insbesondere eine Reihe von Kontaktstellen, die in dem Abschnitt des Interposers angeordnet sind, der aus der Kunststoffumspritzung beziehungsweise aus dem Kunststoffgehäuse herausragt.

Gemäß einer vorteilhaften Weiterbildung der Erfindung ist vorgesehen, dass der Interposer wenigstens eine weitere Kontaktstelle aufweist, die innerhalb der Kunststoffumspritzung liegt, und durch Bearbeiten, insbesondere Laser-Bearbeiten der Kunststoffumspritzung freigelegt/freilegbar ist. Zusätzlich zu der einen oder den mehreren Kontaktstellen, die auf dem außen liegenden Abschnitt des Interposers angeordnet sind, ist also mindestens eine weitere Kontaktstelle innerhalb der Kunststoffumspritzung vorgesehen, die bei Bedarf durch Bearbeitung der Kunststoffumspritzung freigelegt werden kann. Dadurch ergeben sich weitere Verwendungsmöglichkeiten für das MID-Bauteil und insbesondere eine modulartige Gestaltung, die es erlaubt, das MID-Bauteil an bestimmte Anwendungszwecke durch Freilegen bestimmter Kontaktstellen anzupassen.

Das erfindungsgemäße Verfahren mit den Merkmalen des Anspruchs 6 zur Herstellung des oben beschriebenen MID-Bauteils zeichnet sich dadurch aus, dass zunächst ein flexibler Interposer bereitgestellt wird, der wenigstens eine elektrisch leitende Kontaktstelle aufweist, anschließend wenigstens ein elektrisches/elektronisches Bauteil auf den Interposer zum Herstellen eines bestückten Interposers aufgebracht wird, und dass dann der Interposer mit Kunststoff derart umspritzt wird, insbesondere mittels eines Spritzgusswerkzeugs, dass ein die Kontaktstelle aufweisender Abschnitt des Interposers außerhalb der Kunststoffumspritzung liegt. Es ergibt sich hierdurch das oben bereits beschriebene MID-Bauteil mit den genannten Vorteilen.

Vorzugsweise wird als Interposer eine Interposerfolie bereitgestellt, die sich durch eine besondere Flexibilität auszeichnet.

Gemäß einer vorteilhaften Weiterbildung des erfindungsgemäßen Verfahrens ist vorgesehen, dass der Interposer mit wenigstens einer weiteren Kontaktstelle bereitgestellt wird, die durch die Kunststoffumspritzung eingehaust wird. Es sind somit weitere Kontaktstellen innerhalb des Kunststoffgehäuses vorgesehen, die bei Bedarf genutzt werden können.

Bevorzugt ist hierzu vorgesehen, dass durch Einbringen von Öffnungen wenigstens eine der weiteren Kunststoffumspritzungen freigelegt wird. Dadurch lässt sich das MID-Bauteil leicht an unterschiedliche Rahmenbedingungen und Anwendungsfunktionen anpassen.

Weiterhin ist bevorzugt vorgesehen, dass die Öffnungen durch Laserbearbeitung der Kunststoffumspritzung eingebracht werden. Durch die Laserbearbeitung lassen sich die Öffnungen besonders präzise in das Gehäuse einbringen, wobei gleichzeitig eine Beschädigung der Interposerfolie auf einfache Art und Weise vermieden wird. Wobei es selbstverständlich natürlich auch möglich ist, die Öffnungen durch mechanische Bearbeitung der Kunststoffumspritzung beziehungsweise des Gehäuses einzubringen.

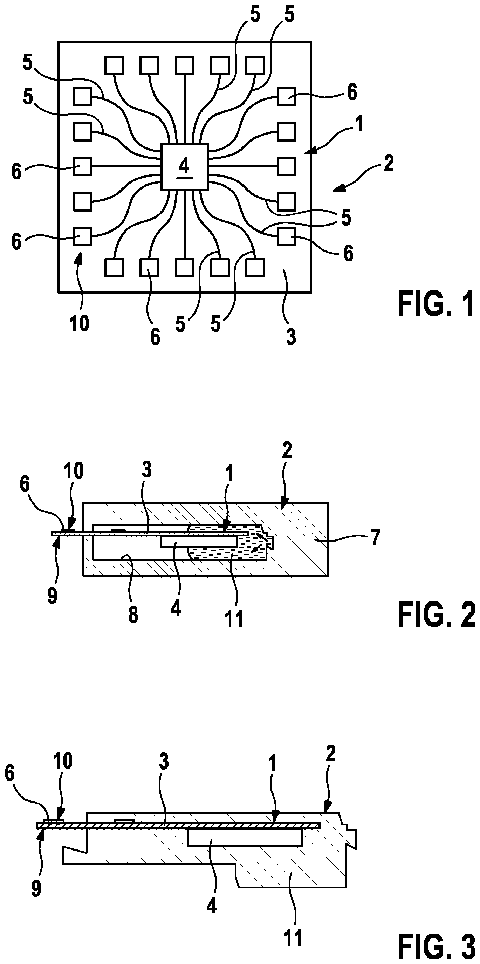

Im Folgenden soll die Erfindung anhand der Zeichnung näher erläutert werden. Dazu zeigen
- Figuren 1 bis 5: ein Verfahren zur Herstellung eines vorteilhaften MID-Bauteils in mehreren Schritten.

Figur 1 zeigt in einer vereinfachten Draufsicht einen Interposer 1 für ein in Figur 1 nicht näher dargestelltes MID-Bauteil 2. Der Interposer 1 weist einen flächigen Schaltungsträger 3 auf, das vorzugsweise als flexible Folie ausgebildet ist. Vorliegend ist der Interposer 1 also als Interposerfolie ausgebildet. Auf dem Schaltungsträger 3 ist ein elektronisches Bauteil 4 mittig angeordnet, das als integrierter Schaltkreis (IC) beziehungsweise als Chip ausgebildet ist. Das Bauteil 4 ist durch Leiterbahnen 5, von denen hier aus Übersichtlichkeitsgründen nur einige mit Bezugszeichen versehen sind, mit Kontaktstellen 6 verbunden, die als Kontaktplättchen ausgebildet sind. Auch von den Kontaktstellen 6 sind aus den zuvor genannten Gründen nur einige mit Bezugszeichen versehen. Die Kontaktstellen 6 sind am Außenrand des Schaltungsträgers 3 im Wesentlichen gleichmäßig verteilt angeordnet und dienen zur einfachen elektrischen Kontaktierung des Bauteils 4. Durch die Verlagerung der Kontaktstellen 6 nach außen, also von dem Bauteil weg, liegen sie weiter beabstandet zueinander und können selbst größer ausgebildet sein, wodurch die elektrische Kontaktierung des Bauteils 4 vereinfacht wird. Der Interposer 1 beziehungsweise der Schaltungsträger 3 ist gemäß einem hier nicht dargestellten Ausführungsbeispiel bevorzugt zwei- oder mehrlagig ausgebildet, um die Entflechtung der Kontaktstellen des Bauteils 4 und die Schaltkreisgestaltung weiter zu optimieren. Auch ist es denkbar, auf der hier nicht ersichtlichen Rückseite des Schaltungsträgers 3 weitere Kontaktstellen und gegebenenfalls auch ein oder mehrere elektrische/elektronische Bauteile vorzusehen.

Das Bauteil 4 wird beispielsweise durch Flip-Chip-Montagetechnologie auf dem Schaltungsträger 3 aufgebracht. Natürlich können auch weitere elektrische/elektronische Bauteile auf dieser Seite des Schaltungsträgers 3 aufgebracht werden. Zweckmäßigerweise sind auch das oder die Bauteile dünn ausgebildet, um einen insgesamt dünnen Aufbau zu bieten und zum anderen eine Montageflexibilität zu gewährleisten. Die Kontaktstellen 6 beziehungsweise die Kontaktplättchen sind bevorzugt mit einer edlen Oberfläche beschichtet, um anschließend beispielsweise mit einer Silber-Leitpaste kontaktiert werden zu können. Alternativ kann auch ein geeignetes bestehendes Package mit kompatibler Technologie für die Integration genutzt werden. Darüber hinaus ist es auch denkbar, ein oder mehrere elektrische/elektronische Bauteile in den Interposer zu integrieren beziehungsweise in den Interposer integriert auszubilden.

Figuren 2 bis 5 zeigen in schematischen Schnittdarstellungen, wie der Interposer 1 dazu genutzt wird, das MID-Bauteil 2 herzustellen. Das Herstellungsverfahren beginnt also mit der Bereitstellung des Interposers 1.

In einem darauffolgenden Schritt wird gemäß Figur 2 der mit dem Bauteil 4 bestückte Interposer 1 in ein Spritzwerkzeug 7, das eine Spritzgussform 8 aufweist, eingesetzt. Dabei wird der Interposer 1 in der Spritzgussform 8 derart gehalten, dass ein Randabschnitt 9 mit einer Reihe 10 der Kontaktstellen 6 sich außerhalb der Spritzgussform 8 befindet, während das Bauteil 4 insbesondere innerhalb der Spritzgussform angeordnet ist.

Wird nun Kunststoff in die Spritzgussform eingespritzt, so wird der Interposer 1 mit dem Kunststoff derart bereichsweise umspritzt, dass der Randabschnitt 9 frei bleibt und nur der in der Spritzgussform 8 liegende Teil des Interposers 1 eingehaust wird. Als Kunststoff wird vorzugsweise Flüssigkristallpolymer (LCP) verwendet, es sind aber auch andere Kunststoffe denkbar, wie beispielsweise PA4, PA6, PA10 oder PEEK, PPS oder PEL.
Figur 3 zeigt das MID-Bauteil 2 nach dem erfolgten Umspritzvorgang, nach der Entnahme aus dem Spritzgusswerkzeug 7. Während der bestückte Interposer 1 im Wesentlichen durch die Kunststoffumspritzung 11 eingehaust ist, verbleibt der Randbereich 9 außerhalb der Kunststoffumspritzung, so dass die Kontaktstellen 6 der Kontaktreihe 10 freiliegen und kontaktierbar sind.

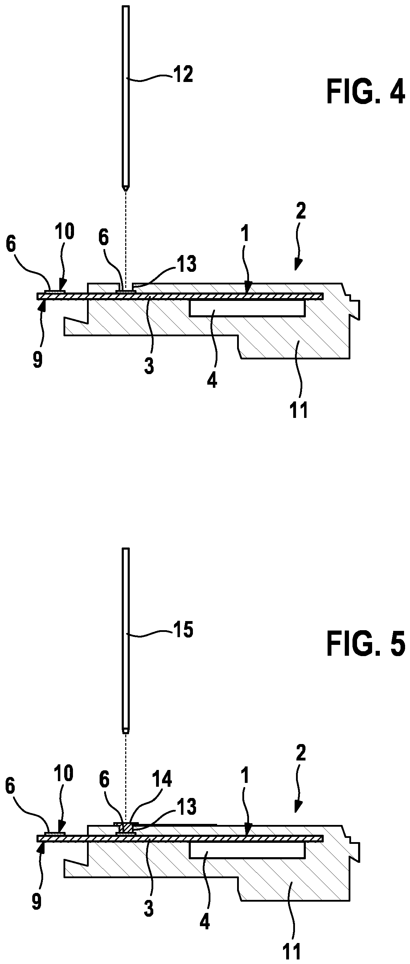

Der nun freiliegende Randbereich 9 des Interposers 1 ist aufgrund der Interposerfolie flexibel ausgebildet und lässt sich beispielsweise zum Kontaktieren leicht verformen beziehungsweise verbiegen. Dadurch kann das Kontaktieren des MID-Bauteils 2 weiter vereinfacht werden. Insbesondere kann der Randabschnitt 9 eine Steckerleiste bilden, die in einen entsprechenden Gegenstecker einführbar ist.
Bevorzugt wird, nachdem die Kunststoffumspritzung 11 ausgehärtet ist, gemäß Figur 4 an wenigstens einer Kontaktstelle 6, die innerhalb der Kunststoffumspritzung 11 liegt, der Kunststoff wieder entfernt. Dazu wird das MID-Bauteil 2 einer Laserbearbeitung mittels eines Laserwerkzeugs 12 unterzogen. Mittels des Laserwerkzeugs 12 wird die Kunststoffumspritzung 11 an der Kontaktstelle 6 innerhalb der Kunststoffumspritzung 11 durch Laserbohren entfernt, wodurch die darunter liegenden Kontaktstelle 6 freigelegt wird.
Durch die entstandene Öffnung 13 in der Kunststoffumspritzung 11 kann dann die Kontaktstelle 6 innerhalb der Kunststoffumspritzung 11 kontaktiert werden. Zusätzlich kann mit der Laserbearbeitung im Falle einer LDS-Technologie (Laser-Direkt-Strukturierung) die Kunststoffumspritzung 11 beziehungsweise der Kunststoff an den Stellen, wo später eine zusätzliche Metallisierung vorgesehen werden soll, strukturiert werden. Vorzugsweise wird die Öffnung 13 aktiviert beziehungsweise metallisiert. Dazu wird bevorzugt ein Plasmaverfahren,

Jetverfahren oder ein galvanisches Abscheideverfahren verwendet. Das Materialabscheiden kann in Kombination mit der Metallisierung des MID-Bauteils erfolgen. Dadurch wird die Öffnung 13 als Durchkontaktierung ausgebildet. Der Laserprozess kann auch hier bei Anwendung unterschiedlicher MID-Strukturierungstechnologien vor oder nach der Metallisierung angewendet werden. Hier ist beispielsweise das 2-Komponenten-Spritzguss- oder Heißprägeverfahren eine mögliche Alternative. Durch die metallisierte Öffnung 13 ist nunmehr die Kontaktstelle 6 innerhalb der Kunststoffumspritzung 11 frei zugängig. Natürlich können so auch noch weitere der Kontaktstellen 6 freigelegt werden.

Figur 5 zeigt hierzu beispielhaft die Herstellung einer Durchkontaktierung 14 mittels Jetverfahren durch ein entsprechendes Jetwerkzeug 15. Auf dem MID-Bauteil 2 mit dem integrierten Bauteil 4, dessen Kontakte über die Kontaktstellen 6 kontaktierbar sind, wird nun eine Metallisierung von Leiterbahnen auf der Außenseite des MID-Bauteils 2 durchgeführt, und zwar auf der Seite, auf welcher auch die Öffnung 13 vorgesehen ist, so dass die Öffnung 13, insbesondere die Durchkontaktierung 14 direkt mit den Leiterbahnen verbunden werden kann. Die Leiterbahnen können dabei durch Laserdirektstrukturierung, Galvanisierung, Jetauftragungsverfahren, Dosiertechnik oder Plasmaauftragungsverfahren hergestellt werden. Insbesondere wird dabei gleichzeitig der elektrische Kontakt zu der Kontaktstelle 6 innerhalb der Kunststoffumspritzung 11 direkt oder mittels der Durchkontaktierungen hergestellt.

Bei dem 2-Komponenten-Spritzguss- und Heißprägen wird die Öffnung 13 bevorzugt durch Jetverfahren oder das Dosieren von Leitpasten gleichzeitig, vor oder nach der Herstellung der Leiterbahnen hergestellt. Alternativ kann durch eine Jetkontaktierung im Prozess der Herstellung der Leiterbahnen gleichzeitig die jeweilige Öffnung 13 durch Füllen mit elektrisch leitfähigem Material metallisiert werden. Bei Plasmaverfahren, insbesondere bei Plasmasprayen, wird der Kontakt zu den elektrischen Komponenten beziehungsweise zu der jeweiligen Kontaktstelle 6 zusätzlich mit hergestellt. Zusätzlich können diese Kontakte zum Beispiel auch durch Dosieren von Leitpaste oder galvanisch verstärkt werden. Wird eine Laserdirektstrukturierung mit galvanischer Herstellung der Leiterbahnen durchgeführt, so werden die elektrischen Kontakte zweckmäßigerweise in demselben Galvanikprozess hergestellt, wie auch bei der Abscheidung der Leiterbahnen. Voraussetzung dafür ist, dass die Metallplättchen oder Metallpads der Kontaktstellen 6 eine kompatible Metallisierung wie beispielsweise Kupfer, eine Nickel-Pd-Beschichtung oder plasmaabgeschiedenes Kupfer aufweist, insbesondere ohne dass die isolierte Seitenwand der Öffnung 13 eine Bekeimung oder eine Plasmametallabscheidung aufweist.

Auf die Außenseite der Kunststoffumspritzung 11 können, wie bei herkömmlicher MID-Technologie, weitere elektrische/elektronische Bauteile und/oder Leiterbahnen aufgebracht werden, unter Nutzung bekannter Technologien, wie Leitkleben, Löt- oder Drahtbonden.

Das Schaltungsträger 3 beziehungsweise der Interposer 1 wird vorzugsweise planar hergestellt, wobei auch ein nachträgliches Verformen in eine dreidimensionale Struktur aufgrund der flexiblen Interposerfolie, insbesondere vor dem Umspritzen möglich und bevorzugt ist, um ein dreidimensional geformtes MID-Bauteil 2 herzustellen. Hierdurch werden bei der Herstellung von dreidimensionalen MID-Bauteilen Herstellungskosten reduziert. Durch das vorteilhafte MID-Bauteil 2 ist es außerdem möglich, Leitungskreuzungen in MID-Technologie durch den Einsatz des Interposers 1 zu erreichen. Als Substratmaterialien können auch Silikone oder Thermoplaste verwendet werden, um ein stretchbares oder plastisch verformbares Substrat zu erhalten. Wird der Schichtaufbau des MID-Bauteils 2 derart ausgeführt, dass seine Formgebung durch plastisches Verformen, beispielsweise durch einen Prägeprozess realisiert werden kann, so ist die Realisierung des Interposers 1 in dreidimensionaler Form möglich und somit eine Ausbildung als angepasstes Einlegeteil kostengünstig zur Verfügung gestellt. Durch den Interposer 1 wird darüber hinaus eine zusätzliche Fläche für großflächige Ankontaktierungsprozesse mit elektronischer Umgebung, beispielsweise Steckverbinder, Klemmkontakte oder dergleichen, insbesondere auch durch den freien Randabschnitt 9 geboten.

## Patentansprüche

1. MID-Bauteil (2) für ein Steuergerät oder einen Sensor, insbesondere eines Fahrzeugs, mit einem Schaltungsträger (3) und mit einer Kunststoffumspritzung (11), die den Schaltungsträger (3) zumindest bereichsweise einhaust, **dadurch gekennzeichnet, dass** der Schaltungsträger (3) als flexibler Interposer (1) ausgebildet ist, der mit mindestens einem elektrischen/elektronischen Bauteil (4) bestückt ist und wenigstens eine elektrisch leitende Kontaktstelle (6) aufweist, und dass ein die Kontaktstelle (6) aufweisender Abschnitt (9) des Interposers (1) außerhalb der Kunststoffumspritzung (11) angeordnet ist.

2. Bauteil nach Anspruch 1, **dadurch gekennzeichnet, dass** der Abschnitt (9) ein Randabschnitt des Interposers (1) ist.

3. Bauteil nach einem der vorhergehenden Ansprüche, **dadurch gekennzeichnet, dass** der Interposer (1) als Interposerfolie ausgebildet ist.

4. Bauteil nach einem der vorhergehenden Ansprüche, **dadurch gekennzeichnet, dass** das elektrische/elektronische Bauteil (4) von der Kunststoffumspritzung (11) eingehaust ist.

5. Bauteil nach einem der vorhergehenden Ansprüche, **dadurch gekennzeichnet, dass** der Interposer (1) wenigstens eine weitere Kontaktstelle aufweist, die innerhalb der Kunststoffumspritzung (11) liegt und durch Bearbeitung, insbesondere Laserbearbeitung der Kunststoffumspritzung (11) freilegbar/freigelegt ist.

6. Verfahren zur Herstellung eines MID-Bauteils (2), insbesondere nach einem der vorhergehenden Ansprüche, mit folgenden Schritten:
- Bereitstellen eines flexiblen Interposers (1), der wenigstens eine elektrisch leitende Kontaktstelle (6) aufweist,
- Aufbringen wenigstens eines elektrischen/elektronischen Bauteils (4) auf den Interposer (1) zum Herstellen eines bestückten Interposers,
- Umspritzen des bestückten Interposers mit Kunststoff derart, dass ein die Kontaktstelle (6) aufweisender Abschnitt (9) des Interposers (1) außerhalb der Kunststoffumspritzung (11) liegt.

7. Verfahren nach Anspruch 6, **dadurch gekennzeichnet, dass** als Interposer (1) eine Interposerfolie bereitgestellt wird.

8. Verfahren nach einem der vorhergehenden Ansprüche, **dadurch gekennzeichnet, dass** der Interposer mit wenigstens einer weiteren Kontaktstelle (6) bereitgestellt wird, die durch die Kunststoffumspritzung (11) eingehaust wird.

9. Verfahren nach Anspruch 8, **dadurch gekennzeichnet, dass** die eine weitere Kontaktstelle innerhalb der Kunststoffumspritzung (11) durch Einbringen einer Öffnung (13) in die Kunststoffumspritzung (11) freigelegt wird.

10. Verfahren nach Anspruch 9, **dadurch gekennzeichnet, dass** die Öffnung (13) durch Laserbearbeitung der Kunststoffumspritzung (11) eingebracht wird.

## Claims

1. MID component (2) for a control device or a sensor, in particular of a vehicle, with a circuit carrier (3) and with a plastic encapsulation (11), which houses the circuit carrier (3) at least in certain regions, **characterized in that** the circuit carrier (3) is formed as a flexible interposer (1), which is populated with at least one electrical/ electronic component (4) and has at least one electrically conducting contact location (6), and **in that** a portion (9) of the interposer (1) that has the contact location (6) is arranged outside the plastic encapsulation (11).

2. Component according to Claim 1, **characterized in that** the portion (9) is a peripheral portion of the interposer (1).

3. Component according to one of the preceding claims, **characterized in that** the interposer (1) is formed as an interposer film.

4. Component according to one of the preceding claims, **characterized in that** the electrical/electronic component (4) is housed by the plastic encapsulation (11).

5. Component according to one of the preceding claims, **characterized in that** the interposer (1) has at least one further contact location, which lies within the plastic encapsulation (11) and can be exposed/is exposed by machining, in particular laser machining, of the plastic encapsulation (11).

6. Method for producing an MID component (2), in particular according to one of the preceding claims, with the following steps:
- providing a flexible interposer (1), which has at least one electrically conducting contact location (6),
- applying at least one electrical/electronic component (4) to the interposer (1) for producing a populated interposer,
- encapsulating the populated interposer with plastic in such a way that a portion (9) of the interposer (1) that has the contact location (6) lies outside the plastic encapsulation (11).

7. Method according to Claim 6, **characterized in that** an interposer film is provided as the interposer (1) .

8. Method according to one of the preceding claims, **characterized in that** the interposer with at least one further contact location (6), which is housed by the plastic encapsulation (11), is provided.

9. Method according to Claim 8, **characterized in that** the one further contact location within the plastic encapsulation (11) is exposed by introducing an opening (13) into the plastic encapsulation (11).

10. Method according to Claim 9, **characterized in that** the opening (13) is introduced by laser machining the plastic encapsulation (11).

## Revendications

1. Composant MID (2) pour un appareil de commande ou un capteur, en particulier d'un véhicule, présentant un porte-circuit (3) et une encapsulation (11) en matière synthétique qui englobe au moins certaines parties du porte-circuit (3), **caractérisé en ce que** le porte-circuit (3) est configuré comme intercalaire flexible (1) qui équipé d'au moins un composant électrique/électronique (4) et présente au moins un emplacement de contact (6) électriquement conducteur et **en ce qu'**une section (9) de l'intercalaire (1) qui présente l'emplacement de contact (6) est disposée à l'extérieur de l'encapsulation (11) en matière synthétique.

2. Composant selon la revendication 1, **caractérisé en ce que** la section (9) est une partie de bord de l'intercalaire (1).

3. Composant selon l'une des revendications précédentes, **caractérisé en ce que** l'intercalaire (1) est configuré en tant que feuille d'intercalaire.

4. Composant selon l'une des revendications précédentes, **caractérisé en ce que** le composant électrique/électronique (4) est encapsulé dans l'encapsulation (11) en matière synthétique.

5. Composant selon l'une des revendications précédentes, **caractérisé en ce que** l'intercalaire (1) présente au moins un autre emplacement de contact disposé à l'intérieur de l'encapsulation (11) en matière synthétique et peut être libéré ou est libéré par traitement, en particulier par traitement au laser de l'encapsulation (11) en matière synthétique.

6. Procédé de fabrication d'un composant MID (2), en particulier selon l'une des revendications précédentes, le procédé présentant les étapes suivantes :
- préparer un intercalaire flexible (1) qui présente au moins un emplacement de contact (6) électriquement conducteur,
- appliquer au moins un composant électrique/électronique (4) sur l'intercalaire (1) en vue de former un intercalaire équipé,
- englober l'intercalaire équipé dans une matière synthétique de telle sorte qu'une section (9) de l'intercalaire (1) qui présente l'emplacement de contact (6) soit située à l'extérieur de l'encapsulation (11) en matière synthétique.

7. Procédé selon la revendication 6, **caractérisé en ce qu'**on utilise en tant qu'intercalaire (1) une feuille d'intercalaire.

8. Procédé selon l'une des revendications précédentes, **caractérisé en ce que** l'intercalaire est équipé d'au moins un autre emplacement de contact (6) englobé dans l'encapsulation (11) en matière synthétique.

9. Procédé selon la revendication 8, **caractérisé en ce que** l'autre emplacement de contact situé à l'intérieur de l'encapsulation (11) en matière synthétique est libéré en ménageant une ouverture (13) dans l'encapsulation (11) en matière synthétique.

10. Procédé selon la revendication 9, **caractérisé en ce que** l'ouverture (13) est ménagée par traitement au laser de l'encapsulation (11) en matière synthétique.
